# EUROPEAN PATENT APPLICATION

(11) **EP 4 148 441 A1**
(43) Date of publication of application: **15.03.2023**
(21) Application number: 21856136.3
(22) Date of filing: 05.08.2021
(51) Int. Cl.: G01R 31/367, G01R 31/36, G01R 31/374, G01R 31/382

(54) **BATTERY MANAGEMENT DEVICE AND METHOD**

(30) Priority: 13.08.2020 KR 20200101933
(71) Applicant: LG Energy Solution, Ltd., Seoul 07335 (KR)
(72) Inventor: KIM, Young-Jin, Daejeon 34122 (KR)
(74) Representative: Plasseraud IP
(86) International application number: PCT/KR2021/010342
(87) International publication number: WO 2022/035130

(57) **Abstract**

A battery management apparatus according to an embodiment of the present disclosure includes: a battery information estimating unit configured to estimate battery information including OCV and SOC for a battery cell based on at least one of voltage and current of the battery cell; a profile generating unit configured to receive the OCV and the SOC from the battery information estimating unit and generate a SOC profile representing a correspondence between the OCV and the SOC; and a control unit configured to receive the SOC profile from the profile generating unit, determine an inflection point in the received SOC profile, set a correction section in the SOC profile based on OCV or SOC corresponding to the inflection point when at least one inflection point exists in the SOC profile, and correct the SOC profile by linearizing the set correction section.

## Description

### TECHNICAL FIELD

The present application claims priority to Korean Patent Application No. 10-2020-0101933 filed on August 13, 2020 in the Republic of Korea, the disclosures of which are incorporated herein by reference.

The present disclosure relates to a battery management apparatus and method, and more particularly, to a battery management apparatus and method capable of generating a SOC profile for a battery cell.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

A method of accurately estimating the state of charge (SOC) of a battery, which has an important effect on the performance of such a battery, is being researched (Non-patent Literature 1). The method for estimating the SOC of a battery can be largely divided into a method using Coulomb counting and a method using an extended Kalman filter (EKF).

The Coulomb counting is a method of estimating the SOC of a battery by adding SOC per hour to an initial SOC (SOC₀) of the battery. The Although Coulomb counting is simple in calculation, but there is a disadvantage that errors accumulate when the initial state of charge (SOC₀) is not accurately known.

The extended Kalman filter is a widely used to estimate the state of a non-linear model. In case of using the extended Kalman filter, OCV (Open Circuit Voltage) may be estimated using an equivalent circuit model (ECM) set for the battery, and the SOC of the battery may be estimated based on the estimated OCV. However, when the extended Kalman filter is used, internal parameters of the equivalent circuit model are converted by various environmental factors such as load current, SOC and temperature, and this appears as an error caused by the model. Therefore, it is required to develop a technology for estimating the SOC of the battery more accurately by correcting the error in the SOC estimated using the extended Kalman filter.

(Non-patent literature 1) Compensation Method of EKF Based on LSTM for Estimating State of Charge of Li-polymer Battery, Transactions of KSAE, Beomjin Yoon, Seougyeol Yoo, Sangman Seong, Vol. 27, No. 7, pp.501-507, July 2019.

### DISCLOSURE

### Technical Problem

The present disclosure is designed to solve the problem of a SOC profile generated using an extended Kalman filter, and the present disclosure is directed to providing a battery management apparatus and method for generating a SOC profile with improved accuracy in estimating a SOC of a battery cell.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure may comprise: a battery information estimating unit configured to estimate battery information including OCV and SOC for a battery cell based on at least one of voltage and current of the battery cell; a profile generating unit configured to receive the OCV and the SOC from the battery information estimating unit and generate a SOC profile representing a correspondence between the OCV and the SOC; and a control unit configured to receive the SOC profile from the profile generating unit, determine an inflection point in the received SOC profile, set a correction section in the SOC profile based on OCV or SOC corresponding to the inflection point when at least one inflection point exists in the SOC profile, and correct the SOC profile by linearizing the set correction section.

The control unit may be configured to remove the inflection point included in the correction section of the SOC profile by applying a linearization algorithm to the correction section.

When a plurality of inflection points exist in the SOC profile, the control unit may be configured to set the correction section for each of the plurality of inflection points and linearize the plurality of set correction sections independently.

When at least two correction sections are overlapped among the plurality of set correction sections, the control unit may be configured to set the plurality of overlapped correction sections as one correction section.

The control unit may be configured to correct the SOC profile multiple times while changing the size of the correction section, calculate a SOC error for each of the plurality of corrected SOC profiles based on a preset reference profile, select a target SOC profile having a minimum calculated SOC error among the plurality of corrected SOC profiles, and set the selected target SOC profile as a criterion profile for the battery cell.

The control unit may be configured to calculate a SOC error rate for each OCV for each of the plurality of corrected SOC profiles by comparing the SOC for each OCV of the reference profile and the SOC for each OCV of the plurality of corrected SOC profiles, and select a corrected SOC profile in which the error section of the calculated SOC error rate for each OCV has a minimum size among the plurality of corrected SOC profiles as the target SOC profile.

The control unit may be configured to select a SOC profile in which the error section representing a difference between a minimum value and a maximum value of the SOC error rate for each OCV calculated for each of the plurality of corrected SOC profiles has a minimum size as the target SOC profile.

The control unit may be configured to set a plurality of filtering sections respectively based on a start point and an end point of the correction section in the corrected SOC profile and apply a filtering algorithm to each of the plurality of set filtering sections.

The plurality of filtering sections may be configured to include a linear section and a non-linear section based on the start point or the end point.

The control unit may be configured to correct each of the plurality of filtering sections by using the filtering algorithm so that the linear section and the non-linear section become continuous sections.

The battery information estimating unit may be configured to estimate the OCV and the SOC corresponding to each other from the voltage and the current of the battery cell by using an equivalent circuit model and an extended Kalman filter.

A battery pack according to another aspect of the present disclosure may comprise the battery management apparatus according to one aspect of the present disclosure.

A battery management method according to still another aspect of the present disclosure may comprise: a battery information estimating step of estimating battery information including OCV and SOC for a battery cell based on at least one of voltage and current of the battery cell; a SOC profile generating step of generating a SOC profile representing a correspondence between the OCV and the SOC estimated in the battery information estimating step; an inflection point determining step of determining an inflection point in the SOC profile; a correction section setting step of setting a correction section in the SOC profile based on OCV or SOC corresponding to the inflection point, when at least one inflection point exists in the SOC profile; and a SOC profile correcting step of correcting the SOC profile by linearizing the correction section set in the correction section setting step.

### Advantageous Effects

According to one aspect of the present disclosure, the battery management apparatus according to an embodiment of the present disclosure has an advantage of generating a more stable SOC profile by correcting the SOC profile of a battery cell generated based on the extended Kalman filter by using a linearization algorithm.

In addition, according to one aspect of the present disclosure, when an inflection point is included in the generated SOC profile, the battery management apparatus according to an embodiment of the present disclosure may primarily correct the SOC profile by applying a linearization algorithm to the correction section set to include the inflection point, and secondarily correct the SOC profile by applying a filtering algorithm to a partial section of the primarily corrected SOC profile.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery management apparatus according to an embodiment of the present disclosure.
FIG. 2 is a diagram schematically showing a SOC profile generated by the battery management apparatus according to an embodiment of the present disclosure.
FIG. 3 is a diagram showing an example of an inflection point included in the SOC profile of FIG. 2.
FIG. 4 is a diagram schematically showing a SOC profile to which a correction section is set by the battery management apparatus according to an embodiment of the present disclosure.
FIG. 5 is a diagram schematically showing an example where the SOC profile of FIG. 4 is corrected by the battery management apparatus according to an embodiment of the present disclosure.
FIG. 6 is a diagram comparatively showing a SOC error rate of the SOC profile of FIG. 2 and a SOC error rate of the corrected SOC profile of FIG. 5.
FIG. 7 is a diagram schematically showing a SOC profile to which a plurality of correction sections are set by the battery management apparatus according to an embodiment of the present disclosure.
FIG. 8 is a diagram schematically showing an example where the SOC profile of FIG. 7 is corrected by the battery management apparatus according to an embodiment of the present disclosure.
FIG. 9 is a diagram schematically showing a SOC profile to which a plurality of filtering sections are set by the battery management apparatus according to an embodiment of the present disclosure.
FIG. 10 is an enlarged view showing a part of the SOC profile of FIG. 9.
FIG. 11 is a diagram schematically showing an exemplary configuration of a battery pack including the battery management apparatus according to an embodiment of the present disclosure.
FIG. 12 is a diagram schematically showing a battery management method according to another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

Furthermore, the term "control unit" described in the specification refers to a unit that processes at least one function or operation, and may be implemented by hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

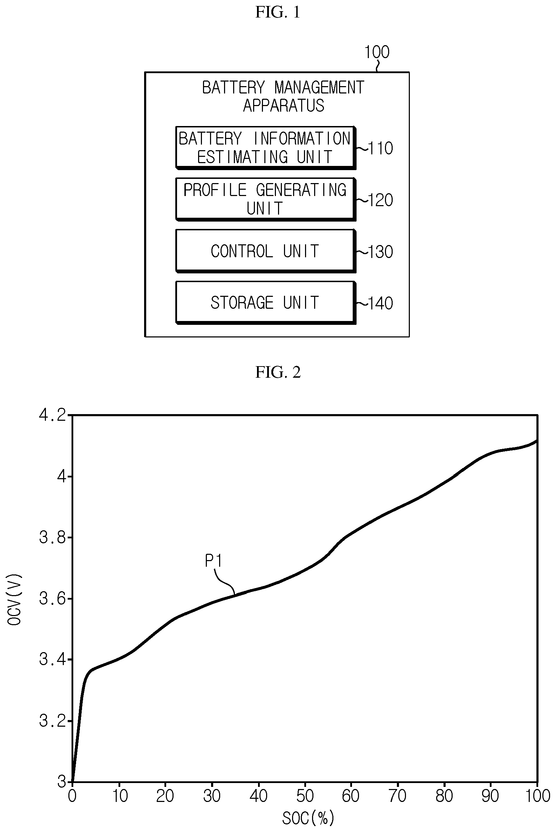

FIG. 1 is a diagram schematically showing a battery management apparatus 100 according to an embodiment of the present disclosure.

Referring to FIG. 1, the battery management apparatus 100 according to an embodiment of the present disclosure may include a battery information estimating unit 110, a profile generating unit 120, and a control unit 130.

The battery information estimating unit 110 may be configured to estimate battery information including OCV and SOC for a battery cell B based on at least one of voltage and current of the battery cell B.

Here, the battery cell B means one independent cell that includes a negative electrode terminal and a positive electrode terminal and is physically separable. For example, one pouch-type lithium polymer cell may be regarded as the battery cell B.

In addition, the OCV means an open circuit voltage, and the SOC means a state of charge.

Specifically, the battery information estimating unit 110 may be configured to estimate the OCV and the SOC corresponding to each other from the voltage and the current of the battery cell B by using an equivalent circuit model (ECM) and an extended Kalman filter (EKF). Since the method of estimating OCV and SOC of a battery from voltage and current of a battery and an equivalent circuit model by using an extended Kalman filter is a known method, a detailed description thereof will be omitted.

The profile generating unit 120 may be configured to receive the OCV and the SOC from the battery information estimating unit 110.

Preferably, the profile generating unit 120 and the battery information estimating unit 110 may be connected to each other to enable communication. When the battery information estimating unit 110 outputs the estimated OCV and SOC, the profile generating unit 120 may receive the OCV and SOC from the battery information estimating unit 110.

In addition, the profile generating unit 120 may be configured to generate an SOC profile representing a correspondence between the OCV and the SOC.

Specifically, the SOC profile may be a profile representing the correspondence between the OCV and the SOC estimated by the battery information estimating unit 110.

FIG. 2 is a diagram schematically showing a SOC profile P1 generated by the battery management apparatus 100 according to an embodiment of the present disclosure.

For example, in the embodiment of FIG. 2, the SOC profile P1 is an X-Y graph where the SOC is set to X and the OCV is set to Y. In addition, the entire section of the SOC of the SOC profile P1 may be 0% to 100%. That is, the SOC profile P1 is a diagram showing OCV and SOC in a one-to-one relationship in the form of a flat graph.

The control unit 130 may be configured to receive the SOC profile P1 from the profile generating unit 120.

Preferably, the control unit 130 may be communicatively connected to the profile generating unit 120. In addition, when the profile generating unit 120 outputs the generated SOC profile P1, the control unit 130 may receive the SOC profile P1 from the profile generating unit 120.

In addition, the control unit 130 may be configured to determine an inflection point in the received SOC profile P1.

Here, the inflection point means a point at which the graph changes from an upwardly convex state to a downwardly convex state or from a downwardly convex state to an upwardly convex state in a function that is differentiable twice. In general, in a flat curve, a point at which the curvature changes from positive to negative or from positive to negative is called an inflection point.

For example, the control unit 130 may set the SOC profile P1 representing the correspondence between the OCV and the SOC as a f(x) function, and differentiates the f(x) function twice to obtain a second derivative f"(x) of the SOC profile P1. Here, it is assumed that the function f(x) is continuous and can be differentiated twice. In addition, the control unit 130 may determine a point at which the sign of the f"(x) changes from positive to negative or from negative to positive based on f'(SOC) while f'(SOC) = 0 in the second derivative f"(x) as an inflection point.

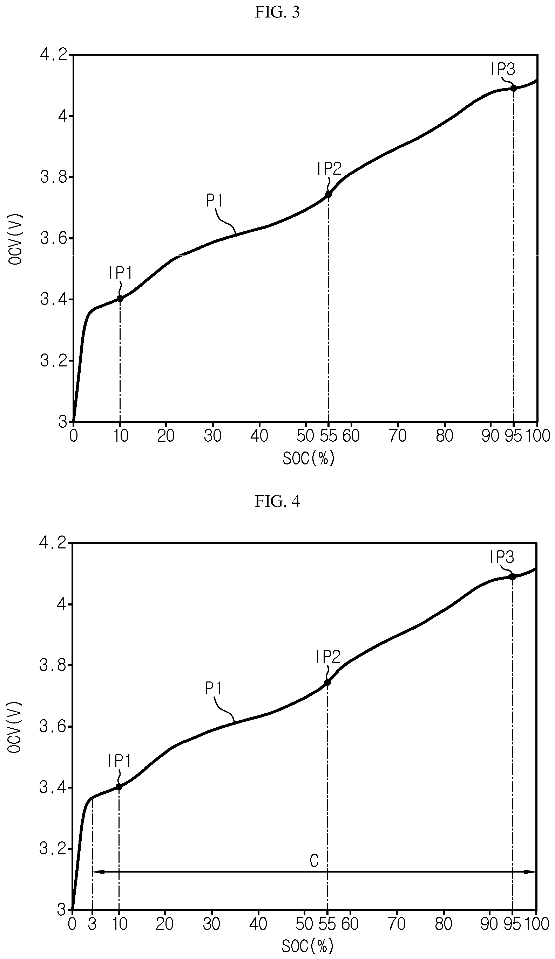

FIG. 3 is a diagram showing an example of the inflection point included in the SOC profile P1 of FIG. 2.

Hereinafter, for convenience of description, as shown in FIG. 3, it is assumed that only a first inflection point IP1, a second inflection point IP2, and a third inflection point IP3 are included in the SOC profile P1. Here, the SOC of the first inflection point IP1 may be 10%, the SOC of the second inflection point IP2 may be 55%, and the SOC of the third inflection point IP3 may be 95%.

When at least one inflection point exists in the SOC profile P1, the control unit 130 may be configured to set a correction section in the SOC profile P1 based on an OCV or SOC corresponding to the inflection point.

For example, the control unit 130 may set the correction section based on the SOC.

Specifically, the control unit 130 may set the correction section in the SOC profile P1 only when it is determined that an inflection point exists in the SOC profile P1. If the inflection point does not exist in the SOC profile P1, the control unit 130 does not set the correction section in the SOC profile P1, and sets the SOC profile P1 received from the profile generating unit 120 as a criterion profile for the corresponding battery cell B.

More specifically, the control unit 130 may set the correction section to include the inflection point. That is, the correction section set by the control unit 130 may always include an inflection point.

FIG. 4 is a diagram schematically showing a SOC profile P1 to which a correction section C is set by the battery management apparatus 100 according to an embodiment of the present disclosure.

For example, in the embodiment of FIG. 4, the control unit 130 may set the correction section C to include all of the first inflection point IP1, the second inflection point IP2, and the third inflection point IP3 based on the SOC. Here, the correction section C may be an SOC section of 3% to 100%.

In addition, the control unit 130 may be configured to correct the SOC profile P1 by linearizing the set correction section C.

Referring to the definition of the inflection point described above, the inflection point may appear in a non-linear section of the SOC profile P1. Accordingly, the control unit 130 may correct the SOC profile P1 by linearizing the non-linear section including the inflection point.

That is, the control unit 130 may be configured to remove the inflection point included in the correction section C of the SOC profile P1 by applying a linearization algorithm to the correction section C.

Here, as the linearization algorithm, an algorithm capable of converting a non-linear section of a curve into a linear section may be applied. For example, as the linearization algorithm, a regression analysis method such as a least square method (LSM), a least square approximation (LSA), and a least mean square method (LMSM) may be applied.

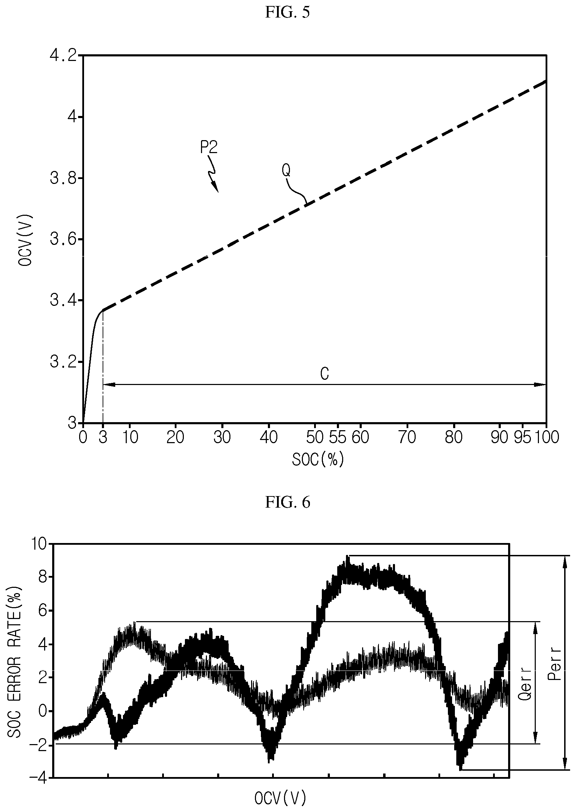

FIG. 5 is a diagram schematically showing an example where the SOC profile P1 of FIG. 4 is corrected by the battery management apparatus 100 according to an embodiment of the present disclosure.

Specifically, the SOC profile P2 of FIG. 5 is an SOC profile obtained by linearizing the correction section C by the control unit 130 using the least square method. Since the correction section C including an inflection point is linearized, the corrected SOC profile P2 may not include an inflection point. In FIG. 5, Q means a linearized correction section C.

Hereinafter, an SOC error rate of the corrected SOC profile P2 from which the inflection point is removed by the control unit 130 and an SOC error rate of the SOC profile P1 including the inflection point will be described with reference to FIG. 6.

FIG. 6 is a diagram comparatively showing a SOC error rate of the SOC profile P1 of FIG. 2 and a SOC error rate of the corrected SOC profile P2 of FIG. 5.

The SOC error rate means the difference in SOC for each OCV between a preset reference profile and the SOC profile for the battery cell B. Here, the reference profile may be a profile preset to represent the correspondence between the OCV and SOC of the battery cell B. For example, the reference profile may be a profile representing the correspondence between the OCV and the SOC for the battery cell B estimated according to a method different from the extended Kalman filter (e.g., Coulomb counting).

For example, the SOC error rate may be calculated according to a formula of "(SOC of SOC profile - SOC of reference profile) ÷ SOC of reference profile × 100" for each OCV. According to the above equation, the unit of the SOC error rate may be expressed as [%].

In the embodiment of FIG. 6, the control unit 130 may calculate the difference between the SOC for each OCV of the reference profile and the SOC for each OCV of the SOC profile (P1, P2) as an SOC error rate.

Referring to FIG. 6, the SOC error rate of the corrected SOC profile P2 in which the inflection point is removed by the control unit 130 may have a small variation, compared to the SOC error rate of the SOC profile P1 including the inflection point. Specifically, the size of the error section (Perr) of the SOC profile P1 may be larger than the size of the error section (Qerr) of the corrected SOC profile P2.

Since the SOC error rate may appear evenly for the total OCV section as the size of the error section is smaller, the SOC profile P2 corrected by the control unit 130 may be regarded as a more suitable profile for the battery cell B than the SOC profile P1 generated by the profile generating unit 120. That is, the SOC profile P2 corrected by the control unit 130 may be a more stable profile than the SOC profile P1 generated by the profile generating unit 120.

For example, when the battery information estimating unit 110 estimates the SOC of the battery cell B using the extended Kalman filter, noise may affect the Kalman gain near the inflection point included in the SOC profile P1. Accordingly, the size of the error section (Perr) of the SOC profile P1 generated by the profile generating unit 120 may be larger than the size of the error section (Qerr) of the SOC profile P2 corrected by the control unit 130. That is, the SOC profile P1 generated by the profile generating unit 120 may not be more stable than the SOC profile P2 corrected by the control unit 130 due to the influence of noise.

Therefore, the battery management apparatus 100 according to an embodiment of the present disclosure has an advantage of generating a more stable SOC profile P1 by correcting the SOC profile P1 of the battery cell B generated based on the extended Kalman filter using a linearization algorithm.

Meanwhile, the control unit 130 provided to the battery management apparatus 100 according to an embodiment of the present disclosure may selectively include processors known in the art, application-specific integrated circuit (ASIC), other chipsets, logic circuits, registers, communication modems, data processing devices, and the like to execute various control logic performed in the present disclosure. Also, when the control logic is implemented in software, the control unit 130 may be implemented as a set of program modules. At this time, the program module may be stored in a memory and executed by the control unit 130. The memory may be located inside or out of the control unit 130 and may be connected to the control unit 130 by various well-known means.

In addition, the battery management apparatus 100 according to an embodiment of the present disclosure may further include a storage unit 140. The storage unit 140 may store data necessary for operation and function of each component of the battery management apparatus 100, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

For example, the storage unit 140 may store voltage information and current information of the battery cell B. In addition, the storage unit 140 may store parameters and functions related to an equivalent circuit model and an extended Kalman filter preset to correspond to the battery cell B.

When a plurality of inflection points exist in the SOC profile P1, the control unit 130 may be configured to set a correction section for each of the plurality of inflection points IP1, IP2, IP3.

For example, in the embodiment of FIG. 4, the control unit 130 sets the correction section C including all of the first inflection point IP1, the second inflection point IP2, and the third inflection point IP3. Alternatively, the control unit 130 may set a correction section for each of the first inflection point IP1, the second inflection point IP2, and the third inflection point IP3.

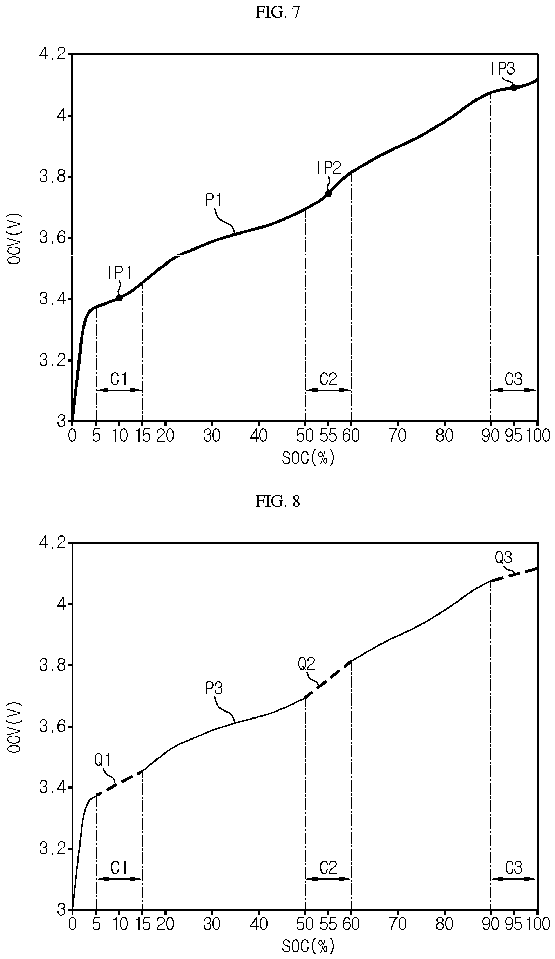

FIG. 7 is a diagram schematically showing a SOC profile P1 to which a plurality of correction sections C1, C2, C3 are set by the battery management apparatus 100 according to an embodiment of the present disclosure.

For example, in the embodiment of FIG. 7, the control unit 130 may set a first correction section C1 for the first inflection point IP1, a second correction section C2 for the second inflection point IP2, and a third correction section C3 for the third inflection point IP3. Here, the first correction section C1 may be an SOC section of 5% to 15%, the second correction section C2 may be an SOC section of 50% to 60%, and the third correction section C3 may be an SOC section of 90% to 100%.

In addition, the control unit 130 may be configured to independently linearize each of the plurality of set correction sections C1, C2, C3.

Specifically, when the SOC profile P1 is corrected by linearizing each of the plurality of correction sections C1, C2, C3, the control unit 130 may set the correction sections C1, C2, C3 so that the inflection point does not exist in the corrected SOC profile P3.

For example, when all inflection points included in the SOC profile P1 are not removed entirely just by the plurality of correction sections C1, C2, C3, the control unit 130 may set one correction section including all of the plurality of inflection points IP1, IP2, IP3 as in the embodiment of FIG. 3.

FIG. 8 is a diagram schematically showing an example where the SOC profile P1 of FIG. 7 is corrected by the battery management apparatus 100 according to an embodiment of the present disclosure.

The control unit 130 may linearize each of the first correction section C1, the second correction section C2, and the third correction section C3. In the embodiment of FIG. 8, Q1 means a linearized first correction section C1, Q2 means a linearized second correction section C2, and Q3 means a linearized third correction section C3. Accordingly, the first inflection point IP1, the second inflection point IP2, and the third inflection point IP3 may be removed from the corrected SOC profile P3 of FIG. 8. That is, an inflection point may not exist in the corrected SOC profile P3.

In addition, in the embodiment of FIGS. 7 and 8, even though the first inflection point IP1, the second inflection point IP2, and the third inflection point IP3 are set as middle points of the first correction section C1, the second correction section C2, and the third correction section C3, respectively, in some cases, a middle point of each of the first correction section C1, the second correction section C2, and the third correction section C3 may not be set to the first inflection point IP1, the second inflection point IP2, and the third inflection point IP3.

Also, although the section sizes of the first correction section C1, the second correction section C2, and the third correction section C3 are all set identically with an SOC of 10%, the section sizes of the first correction section C1, the second correction section C2, and the third correction section C3 may also be set differently from each other in order to remove the plurality of inflection points IP1, IP2, IP3 included in the SOC profile P1.

The battery management apparatus 100 according to an embodiment of the present disclosure may improve the SOC estimation accuracy for the battery cell B by the corrected SOC profile P3 by setting the correction sections C1, C2, C3 for each of the plurality of inflection points IP1, IP2, IP3 and independently linearizing each of the plurality of set correction sections C1, C2, C3.

When at least two of the plurality of set correction sections C1, C2, C3 are overlapped, the control unit 130 may be configured to set the plurality of overlapped correction sections C1, C2, C3 as one correction section.

Unlike the embodiment of FIG. 7, it is assumed that the first correction section C1 and the second correction section C2 are overlapped with each other. For example, it is assumed that the first correction section C1 is set to an SOC section of 5% to 35%, and the second correction section C2 is set to an SOC section of 30% to 60%. In this case, the first correction section C1 and the second correction section C2 may be overlapped with each other in the SOC section of 30% to 35%. In this case, when the control unit 130 linearizes the first correction section C1 and the second correction section C2, respectively, the linearized first correction section C1 and the linearized second correction section C2 may exist together in the SOC section of 30% to 35%. Accordingly, the control unit 130 may integrate the first correction section C1 and the second correction section C2 to set the SOC section of 5% to 60% as one correction section.

The control unit 130 may be configured to correct the SOC profile P1 multiple times while changing the size of the correction section.

For example, the control unit 130 may generate a plurality of corrected SOC profiles by reducing the sizes of the plurality of correction sections C1, C2, C3 by 1% SOC. In this case, the corrected SOC profile P3 of FIG. 8 may be any one of the plurality of corrected SOC profiles.

Preferably, the plurality of corrected SOC profiles generated by the control unit 130 may be stored in the storage unit 140.

In addition, the control unit 130 may be configured to calculate an SOC error for each of the plurality of corrected SOC profiles generated based on the preset reference profile.

For example, it is assumed that 10 SOC profiles corrected by the control unit 130 are generated. The control unit 130 may calculate an SOC error rate for each of the 10 corrected SOC profiles.

Specifically, the control unit 130 may be configured to calculate an SOC error rate for each OCV for each of the plurality of corrected SOC profiles by comparing the SOC for each OCV of the reference profile and the SOC for each OCV of each of the plurality of corrected SOC profiles.

Also, the control unit 130 may be configured to select a target SOC profile having a minimum calculated SOC error rate from among the plurality of corrected SOC profiles.

Here, the minimum SOC error rate means that the size of the error section of the calculated SOC error rate for each OCV among the plurality of corrected SOC profiles is the minimum.

For example, when the corrected SOC profile P3 of FIG. 8 is a SOC profile in which the error section of the calculated SOC error rate for each OCV among the plurality of corrected SOC profiles has a smallest size, the control unit 130 may be configured to select the corrected SOC profile P3 as the target SOC profile.

Specifically, the control unit 130 may be configured to select the corrected SOC profile P3, in which the error section representing a difference between a minimum value and a maximum value of the SOC error rate for each OCV calculated for each of the plurality of corrected SOC profiles has a minimum size, as the target SOC profile.

In addition, the control unit 130 may be configured to set the selected target SOC profile as a criterion profile for the battery cell B.

That is, by setting the target SOC profile whose error section has a smallest size among the plurality of corrected SOC profiles as the criterion profile for the battery cell B, the battery management apparatus 100 may improve the accuracy of the SOC estimation, the stability of the estimation, and the reliability of the estimation for the battery cell B and the same type of secondary battery as the battery cell B based on the set criterion profile.

The control unit 130 may be configured to set a plurality of filtering sections based on each of a start point and an end point of the correction section in the corrected SOC profile P2, P3.

Here, the start point of the correction section means a lowest SOC of the correction section, and the end point of the correction section means a highest SOC of the correction section. For example, in the embodiment of FIG. 8, the start point of the first correction section C1 is an SOC of 5%, and the end point is an SOC of 15%. The start point of the second correction section C2 is 50% SOC, and the end point is 60% SOC. The start point of the third correction section C3 is 90% SOC, and the end point is 100% SOC.

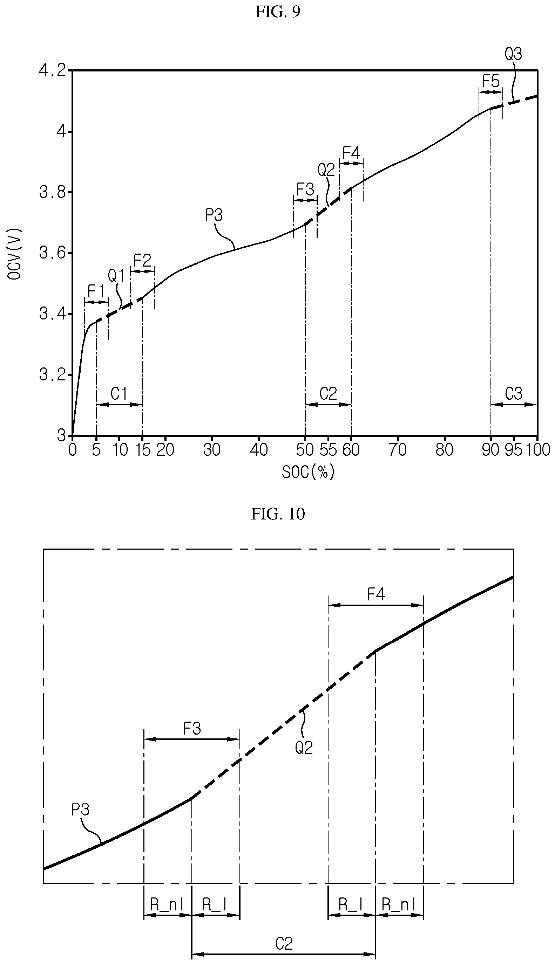

FIG. 9 is a diagram schematically showing a SOC profile P3 to which a plurality of filtering sections are set by the battery management apparatus 100 according to an embodiment of the present disclosure.

In the embodiment of FIG. 9, the control unit 130 may set a first filtering section F1, a second filtering section F2, a third filtering section F3, a fourth filtering section F4, and a fifth filtering section F5. In FIG. 9, since the end point of the third correction section C3 is an SOC of 100%, the control unit 130 may not separately set a sixth filtering section F6 corresponding to the end point of the third correction section C3.

In addition, the control unit 130 may be configured to apply a filtering algorithm to each of the plurality of set filtering sections.

Here, the filtering algorithm may be a smoothing algorithm that may remove noise included in the correction section. As the filtering algorithm, various algorithms may be applied, and, for example, Gaussian smoothing or a low pass filter may be applied.

Specifically, the plurality of filtering sections F1, F2, F3, F4, F5 may be configured to include a linear section and a non-linear section based on the start point or the end point. Here, the non-linear section may be a section existing from the SOC profile P1 generated by the profile generating unit 120, and the linear section may be sections Q, Q1, Q2, Q3 linearized by the control unit 130. The non-linear section and the linear section will be described in detail with reference to FIG. 10.

FIG. 10 is an enlarged view showing a part of the SOC profile P3 of FIG. 9. Specifically, FIG. 10 is an enlarged view exemplarily showing a part of the SOC profile P3 of FIG. 9 near the second correction section C2.

Referring to FIG. 10, the third filtering section F3 and the fourth filtering section F4 may include a non-linear section R_nl and a linear section R_1. For example, in the embodiment of FIG. 10, the linear section R_1 may mean a linearized second correction section C2. That is, since the filtering section includes the start point or the end point of the correction section, both the non-linear section R_nl and the linear section R_1 may be included in the filtering section.

In addition, the control unit 130 may be configured to correct each of the plurality of filtering sections F1, F2, F3, F4, F5 using the filtering algorithm so that the linear section R_1 and the non-linear section R_nl become continuous sections.

For example, it is assumed that the least square method is used as the linearization algorithm. When the control unit 130 linearizes the second correction section C2 using the least square method, the linear section R_1 and the non-linear section R_nl included in the second correction section C2 may not be continuous with each other. That is, the linear section R_1 may not be continuous with the non-linear section R_nl because the least square method is a regression analysis method for approximately deriving an equation in which the sum of the squares of residuals of a plurality of data is minimized.

Therefore, the control unit 130 may correct SOC profile P3 so that the non-linear section R_nl and the linear section R_1 become continuous sections by setting the filtering sections F3, F4 for each of the start point and the end point of the correction section C2 and applying the filtering algorithm to each of the set filtering sections F3, F4.

That is, if the generated SOC profile P1 includes an inflection point, the battery management apparatus 100 according to an embodiment of the present disclosure may primarily correct the SOC profile P1 by applying a linearization algorithm to the correction section set to include an inflection point and secondarily correct the SOC profile P3 by applying a filtering algorithm to a partial section (filtering section) of the primarily corrected SOC profile P3. That is, the SOC profile P3 corrected by the battery management apparatus 100 may more accurately represent the correspondence between the OCV and the SOC for the battery cell B than the SOC profile P1 generated using the extended Kalman filter. Accordingly, according to the SOC profile P3 corrected by the battery management apparatus 100, the accuracy and reliability of the SOC estimation for the battery cell B may be improved.

The battery management apparatus 100 according to the present disclosure may be applied to a BMS (Battery Management System). That is, the BMS according to the present disclosure may include the battery management apparatus 100 described above. In this configuration, at least some of components of the battery management apparatus 100 may be implemented by supplementing or adding functions of components included in a conventional BMS. For example, the battery information estimating unit 110, the profile generating unit 120, the control unit 130, and the storage unit 140 of the battery management apparatus 100 may be implemented as components of the BMS. In addition, the BMS may use the SOC profile corrected by the control unit 130 to estimate the SOC of the battery cell B.

In addition, the battery management apparatus 100 according to the present disclosure may be provided to a battery pack 1. That is, the battery pack 1 according to the present disclosure may include the battery management apparatus 100 described above and at least one battery cell B. In addition, the battery pack 1 may further include electrical equipment (relays, fuses, etc.) and a case.

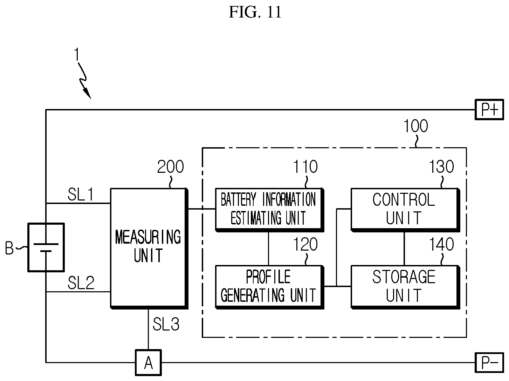

FIG. 11 is a diagram schematically showing an exemplary configuration of a battery pack 1 including the battery management apparatus 100 according to an embodiment of the present disclosure.

Referring to FIG. 11, the battery pack 1 may include a battery cell B, a measuring unit 200, and a battery management apparatus 100.

The measuring unit 200 may be configured to measure the voltage and current of the battery cell B. For example, in the embodiment of FIG. 11, the measuring unit 200 may measure the voltage of the battery through a first sensing line SL1 and a second sensing line SL2. In addition, the measuring unit 200 may measure the current of the battery through a third sensing line SL3 connected to a current measuring unit A.

In addition, the measuring unit 200 may be connected to communicate with the battery information estimating unit 110 of the battery management apparatus 100. Accordingly, when the measuring unit 200 outputs the measured voltage information and current information of the battery cell B, the battery information estimating unit 110 may receive the voltage information and the current information of the battery cell B from the measuring unit 200.

In addition, a load capable of charging or discharging the battery cell B may be further connected to a positive electrode terminal (P+) and a negative electrode terminal (P-) of the battery pack 1.

In addition, the battery management apparatus 100 according to the present disclosure may be included in a battery manufacturing system. Here, the battery manufacturing system may mean a system that can be applied to the process of producing, assembling and inspecting a battery cell B.

The battery management apparatus 100 may be used to obtain the corrected SOC profile P2, P3 for the produced battery cell B in the process of inspecting the battery cell B. That is, the SOC profile P2, P3 corrected by the battery management apparatus 100 may be set as a criterion profile for the corresponding battery cell B. Thereafter, the SOC of the corresponding battery cell B may be estimated based on the criterion profile set by the battery management apparatus 100.

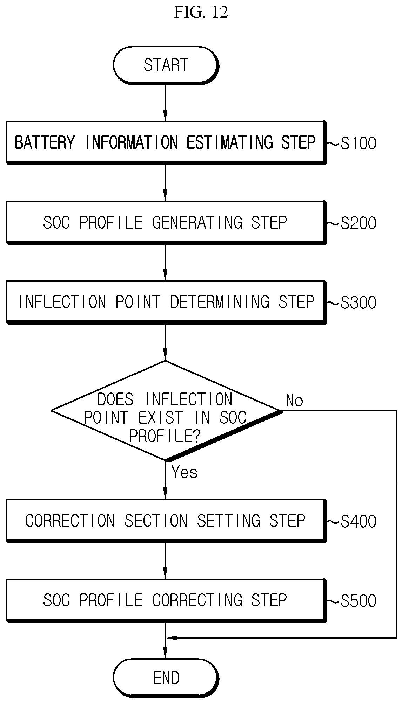

FIG. 12 is a diagram schematically showing a battery management method according to another embodiment of the present disclosure.

Each step of the battery management method may be performed by the battery management apparatus 100. Hereinafter, it should be noted that, for convenience of description, content overlapping with the previously described content will be briefly described or omitted.

Referring to FIG. 12, the battery management method may include a battery information estimating step (S100), a SOC profile generating step (S200), an inflection point determining step (S300), a correction section setting step (S400), and a SOC profile correcting step (S500).

The battery information estimating step (S100) is a step of estimating battery information including OCV and SOC for the battery cell B based on at least one of voltage and current of the battery cell B, and may be performed by the battery information estimating unit 110.

For example, the battery information estimating unit 110 may estimate OCV and SOC for the battery cell B using the voltage and the current of the battery cell B, and a preset equivalent circuit model and extended Kalman filter.

The SOC profile generating step (S200) is a step of generating a SOC profile P1 representing a correspondence between the OCV and the SOC estimated in the battery information estimating step (S100), and may be performed by the profile generating unit 120.

For example, in the embodiment of FIG. 2, the profile generating unit 120 may generate the SOC profile P1.

The inflection point determining step (S300) is a step of determining an inflection point in the SOC profile P1, and may be performed by the control unit 130.

For example, in the embodiment of FIG. 3, the control unit 130 may determine a first inflection point IP1, a second inflection point IP2, and a third inflection point IP3 in the SOC profile P1.

The correction section setting step (S400) and the SOC profile correcting step (S500) may be performed when at least one inflection point exists in the SOC profile P1. If an inflection point does not exist in the SOC profile P1 generated in the SOC profile generating step (S200), the correction section setting step (S400) and the SOC profile correcting step (S500) may not be performed.

Specifically, the correction section setting step (S400) is a step of setting a correction section C in the SOC profile P1 based on the OCV or SOC corresponding to the inflection point, and may be performed by the control unit 130.

For example, in the embodiment of FIG. 4, the control unit 130 may set the correction section C to include the inflection points IP1, IP2, IP3 of the SOC profile P1. Specifically, when the correction section is corrected in the SOC profile correcting step (S500), the control unit 130 may set the correction section so that an inflection point does not exist in the corrected SOC profile.

The SOC profile correcting step (S500) is a step of correcting the SOC profile P1 by linearizing the correction section set in the correction section setting step (S400), and may be performed by the control unit 130.

For example, in the embodiment of FIG. 5, the control unit 130 may remove the inflection points IP1, IP2, IP3 included in the correction section C by linearizing the correction section C. Therefore, since an inflection point does not exist in the corrected SOC profile P2, an SOC error rate of the corrected SOC profile P2 may be smaller than an SOC error rate of the SOC profile P1 generated in the SOC profile generating step (S200).

Also, the control unit 130 may set the corrected SOC profile P2 as a criterion profile for the battery cell B.

Therefore, the battery management method according to another embodiment of the present disclosure has an advantage of setting a more suitable criterion profile for the battery cell B by correcting the SOC profile P1 generated using the extended Kalman filter.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Reference Signs)

1: battery pack
100: battery management apparatus
110: battery information estimating unit
120: profile generating unit
130: control unit
140: storage unit
200: measuring unit
B: battery cell

## Claims

1. A battery management apparatus, comprising:
a battery information estimating unit configured to estimate battery information including OCV and SOC for a battery cell based on at least one of voltage and current of the battery cell;
a profile generating unit configured to receive the OCV and the SOC from the battery information estimating unit and generate a SOC profile representing a correspondence between the OCV and the SOC; and
a control unit configured to receive the SOC profile from the profile generating unit, determine an inflection point in the received SOC profile, set a correction section in the SOC profile based on OCV or SOC corresponding to the inflection point when at least one inflection point exists in the SOC profile, and correct the SOC profile by linearizing the set correction section.

2. The battery management apparatus according to claim 1,
wherein the control unit is configured to remove the inflection point included in the correction section of the SOC profile by applying a linearization algorithm to the correction section.

3. The battery management apparatus according to claim 1,
wherein when a plurality of inflection points exist in the SOC profile, the control unit is configured to set the correction section for each of the plurality of inflection points and linearize the plurality of set correction sections independently.

4. The battery management apparatus according to claim 3,
wherein when at least two correction sections are overlapped among the plurality of set correction sections, the control unit is configured to set the plurality of overlapped correction sections as one correction section.

5. The battery management apparatus according to claim 1,
wherein the control unit is configured to correct the SOC profile multiple times while changing the size of the correction section, calculate a SOC error for each of the plurality of corrected SOC profiles based on a preset reference profile, select a target SOC profile having a minimum calculated SOC error among the plurality of corrected SOC profiles, and set the selected target SOC profile as a criterion profile for the battery cell.

6. The battery management apparatus according to claim 5,
wherein the control unit is configured to calculate a SOC error rate for each OCV for each of the plurality of corrected SOC profiles by comparing the SOC for each OCV of the reference profile and the SOC for each OCV of the plurality of corrected SOC profiles, and select a corrected SOC profile in which the error section of the calculated SOC error rate for each OCV has a minimum size among the plurality of corrected SOC profiles as the target SOC profile.

7. The battery management apparatus according to claim 6,
wherein the control unit is configured to select a SOC profile in which the error section representing a difference between a minimum value and a maximum value of the SOC error rate for each OCV calculated for each of the plurality of corrected SOC profiles has a minimum size as the target SOC profile.

8. The battery management apparatus according to claim 1,
wherein the control unit is configured to set a plurality of filtering sections respectively based on a start point and an end point of the correction section in the corrected SOC profile and apply a filtering algorithm to each of the plurality of set filtering sections.

9. The battery management apparatus according to claim 8,
wherein the plurality of filtering sections are configured to include a linear section and a non-linear section based on the start point or the end point, and
wherein the control unit is configured to correct each of the plurality of filtering sections by using the filtering algorithm so that the linear section and the non-linear section become continuous sections.

10. The battery management apparatus according to claim 1,
wherein the battery information estimating unit is configured to estimate the OCV and the SOC corresponding to each other from the voltage and the current of the battery cell by using an equivalent circuit model and an extended Kalman filter.

11. A battery pack, comprising the battery management apparatus according to any one of claims 1 to 10.

12. A battery management method, comprising:
a battery information estimating step of estimating battery information including OCV and SOC for a battery cell based on at least one of voltage and current of the battery cell;
a SOC profile generating step of generating a SOC profile representing a correspondence between the OCV and the SOC estimated in the battery information estimating step;
an inflection point determining step of determining an inflection point in the SOC profile;
a correction section setting step of setting a correction section in the SOC profile based on OCV or SOC corresponding to the inflection point, when at least one inflection point exists in the SOC profile; and
a SOC profile correcting step of correcting the SOC profile by linearizing the correction section set in the correction section setting step.
